# EUROPEAN PATENT SPECIFICATION

(11) **EP 0 637 087 B1**
(45) Date of publication and mention of the grant of the patent: **16.10.1996**
(21) Application number: 94401714.4
(22) Date of filing: 26.07.1994
(51) Int. Cl.: H01L 39/12, H01L 39/24

(54) **Layered structure comprising insulator thin film and oxide superconductor thin film**
Geschichtete Struktur mit isolierender Dünnschicht und supraleitender Oxyddünnschicht
Structure à couches comprenant une couche mince d'isolateur et une couche mince d'oxyde supraconducteur

(30) Priority: 29.07.1993 JP 207112/93
(43) Date of publication of application: 01.02.1995
(73) Proprietor: SUMITOMO ELECTRIC INDUSTRIES, LIMITED, Osaka 541 (JP)
(72) Inventor: Tokuda, Hitoki, c/o Osaka Works, Konohana-ku, Osaka (JP); Iiyama, Michitomo, c/o Osaka Works, Konohana-ku, Osaka (JP)
(74) Representative: Bernasconi, Jean

(56) References cited:
- EP-A- 0 354 804
- EP-A- 0 446 146
- EP-A- 0 480 814
- US-A- 5 126 315
- APPLIED PHYSICS LETTERS, vol. 54, no. 8, February 20, 1989 WU et al. "High critical currents in epitaxial YBa2Cu3O7-x thin films on silicon with buffer layers" pages 754-756

## Description

### Background of the Invention

### Field of the invention

The present invention relates to a layered structure comprising an insulator thin film and an oxide superconductor thin film, more specifically, to a layered structure comprising an insulator thin film and an oxide superconductor thin film, of which a portion of the insulator thin film can be removed without degradation of the oxide superconductor thin film.

### Description of related art

A superconducting field effect device has a superconducting channel electrically connecting a superconducting source and drain region and a gate electrode on the superconducting channel through a gate insulator. The superconducting field effect device is a voltage control type three-terminal superconducting device having current amplification ability, in which superconducting current flowing through the superconducting channel between the superconducting source and drain region is controlled by a signal voltage applied to the gate electrode. The superconducting field effect device can be manufactured by utilizing oxide superconductors, recently advanced in study, without severe fine processing conditions, so that it is considered to be favorably applicable for practical usage. This type of superconducting field devices are shown in U. S. Patent No. 5,236,896 by Nakamura et al.

The superconducting field device disclosed by Nakamura et al. comprises a superconducting channel formed of an oxide superconductor thin film having a thickness of 5 nanometers and a gate insulator having a thickness of 10 nanometers which is enough to prevent tunnel current. The thickness of the superconducting channel and gate insulator are determined to perform complete ON/OFF operation by a signal voltage of several volts applied to a gate electrode. The superconducting field device also comprises a superconducting source region and a superconducting drain region formed of an oxide superconductor thin film having a thickness of a few hundreds nanometers which is enough to form contacts on them.

In a prior art, the superconducting field effect device is manufactured by a process in which an oxide superconductor thin film which forms a superconducting channel, an insulator thin film and a normal conductor film are deposited in the named order. The normal conductor film and the insulator thin film are completely removed excluding portions which will be a gate electrode and a gate insulating layer. Oxide superconductor thin films are again deposited on the exposed surfaces of the first oxide superconductor thin film so as to form an additional superconducting source region and also superconducting drain region.

In the above superconducting field effect device, in order to apply an electric field to the superconducting channel efficiently, the gate insulator should have a large enough value of electrostatic capacitance than that of the superconducting channel. For this purpose, the gate insulator is required to have the large dielectric constant ε.

In addition, a larger voltage applied to the gate electrode can realize a thicker superconducting channel and gate insulator which relax fabrication conditions of the superconducting channel and gate insulator. For this purpose, the gate insulator should have a large breakdown voltage E_{BD} and a boundary plane between the superconducting channel and gate insulator should be clear enough to prevent unnecessary interfacial energy.

The superconducting channel is often formed of Y₁Ba₂Cu₃O₇₋ₓ oxide superconductor, previously. In this case, the gate insulator is formed of SrTiO₃, see for example EP-A-0 354 804. SrTiO₃ is a ferroelectric having large ε and breakdown voltage. The gate insulator of SrTiO₃ has a value of ε · E_{BD} ≥ 10⁸ V/cm. In addition, a clear boundary plane between a Y₁Ba₂Cu₃O₇₋ₓ oxide superconductor thin filin and a SrTiO₃ thin film can be obtained by depositing a SrTiO₃ thin film successively on the Y₁Ba₂Cu₃O₇₋ₓ oxide superconductor thin film by reactive co-evaporation under high vacuum, so as to reduce the interfacial energy.

However, a field effect device utilizing Y₁Ba₂Cu₃O₇₋ₓ oxide superconductor and SrTiO₃ manufactured by the above conventional process has large contact resistance between the superconducting channel and the additional superconducting source region and between the superconducting channel and the additional superconducting drain region so that it can not obtain required properties.

The inventors' observation using X-ray Photoelectron Spectroscopy (XPS) makes it clear that a strontium contained amorphous layer covered the exposed surface of the Y₁Ba₂Cu₃O₇₋ₓ oxide superconductor thin film after the removal of the SrTiO₃ thin film, which generates the large contact resistance. It is difficult to remove the strontium contained amorphous layer without degrading superconducting properties of the Y₁Ba₂Cu₃O₇₋ₓ thin film.

### Summary of the Invention

Accordingly, it is an object of the present invention to provide a layered structure comprising an insulator thin film and an oxide superconductor thin film, which have overcome the above mentioned defects of the conventional ones.

The above and other objects of the present invention are achieved in accordance with the present invention by a layered structure formed on a substrate comprising a Ly₁Ba₂Cu₃O_{7-δ} (Ly means a lanthanoide or yttrium and 0<δ<1) oxide superconductor thin film deposited on the substrate and an insulator thin film of Ba_{z}Sr_{1-z}TiO₃ (0≤z≤1) deposited on the Ly₁Ba₂Cu₃O_{7-δ} oxide superconductor thin film wherein the insulator thin film is formed of Ba_{z}Sr_{1-z}TiO₃ (0<z≤1) at the bottom.

If the insulator thin film of the layered structure in accordance with the present invention is removed, no strontium contained amorphous layer is remained on an exposed surface of the oxide superconductor thin film. Therefore, contact resistance becomes enough small, when another oxide superconductor thin film or a normal conductor thin film is deposited on the exposed surface of the oxide superconductor thin film.

In the layered structure according to the present invention, the insulator thin film is preferably formed of Ba_{z}Sr_{1-z}TiO₃ in which z is as close as possible to 1 at a portion near the oxide superconductor thin film in order to prevent strontium from producing strontium contained amorphous. However, in order to maintain dielectric properties, the insulator thin film preferably has a portion composed of Ba_{z}Sr_{1-z}TiO₃ in which z is equal to or as close as possible to 0.

Dielectric properties of Ba_{z}Sr_{1-z}TiO₃ (0<z≤1) thin film is determined by deposition methods and deposition conditions. In addition, the dielectric constant, temperature dependency and applied electric field dependency of the dielectric constant of Ba_{z}Sr_{1-z}TiO₃ (0<z≤1) are affected by its composition, namely suffix z.

Therefore, Ba_{z}Sr_{1-z},TiO₃ insulator thin films having different compositions (z) can be used for the insulator thin films so that each insulator thin film has different properties for each application and operating temperature. It is also possible to form the insulator thin film of stacked plural layers of Ba_{z}Sr_{1-z},TiO₃ having different compositions.

For example, although SrTiO₃ has the largest dielectric constant at a temperature lower than 60 K, it is possible to make Ba_{z}Sr_{1-z}TiO₃ have the largest dielectric constant at a temperature approximate to 77 K by selecting an appropriate value of z.

According to one preferable embodiment of the present invention, the insulator thin film is formed of Ba_{0.4}Sr_{0.6}TiO₃.

In another preferable embodiment, the insulator thin film is formed of a tri-layer consisting of a BaTiO₃ layer, a Ba_{0.2}Sr_{0.8}TiO₃ layer and a SrTiO₃ layer stacked in the named order.

It is also preferable that the insulator thin film is formed of a Ba_{z}Sr_{1-z}TiO₃ (0≤z≤1) gradient composition insulator film in which z is equal to 1 at the bottom and z is equal to 0 at the top.

Preferably, the layered structure further comprising a buffer layer between the substrate and the superconductor thin film. The purpose of this buffer layer is to compensate lattice mismatch between the substrate and oxide superconductor and to prevent interdiffusion. For example, the buffer layer is formed of Pr₁Ba₂Cu₃O_{7-y} oxide. Pr₁Ba₂Cu₃O_{7-y} oxide has a crystal structure similar to that of Ly₁Ba₂Cu₃O_{7-δ} (Ly means a lanthanoide or yttrium) oxide superconductor so that the buffer layer of Pr₁Ba₂Cu₃O_{7-y} oxide can compensate lattice mismatch between the substrate and the Ly₁Ba₂Cu₃O_{7-δ} oxide superconductor thin film. In addition, the buffer layer prevents interdiffusion between them. Even if constituent elements of Pr₁Ba₂Cu₃O_{7-y} oxide buffer layer diffuse into the Ly₁Ba₂Cu₃O_{7-δ} oxide superconductor thin film, properties of the oxide superconductor thin film are not affected.

In a preferred embodiment, the oxide thin film is formed of a Y-Ba-Cu-O compound oxide superconductor material.

In addition, the substrate can be formed of an insulating substrate, preferably an oxide single crystalline substrate such as MgO, SrTiO₃, CdNdAlO₄, etc. These substrate materials are very effective in forming or growing a crystalline film on them.

The above and other objects, features and advantages of the present invention will be apparent from the following description of preferred embodiments of the invention with reference to the accompanying drawings.

### Brief Description of the Drawings

Figure 1 is a diagrammatic sectional view of a film deposition apparatus which can be used for manufacturing the layered structure in accordance with the present invention; and
Figures 2A to 2F are diagrammatic sectional views illustrating a process for manufacturing a structure which is used for proving advantage of the layered structure in accordance with the present invention.

### Description of the Preferred embodiments

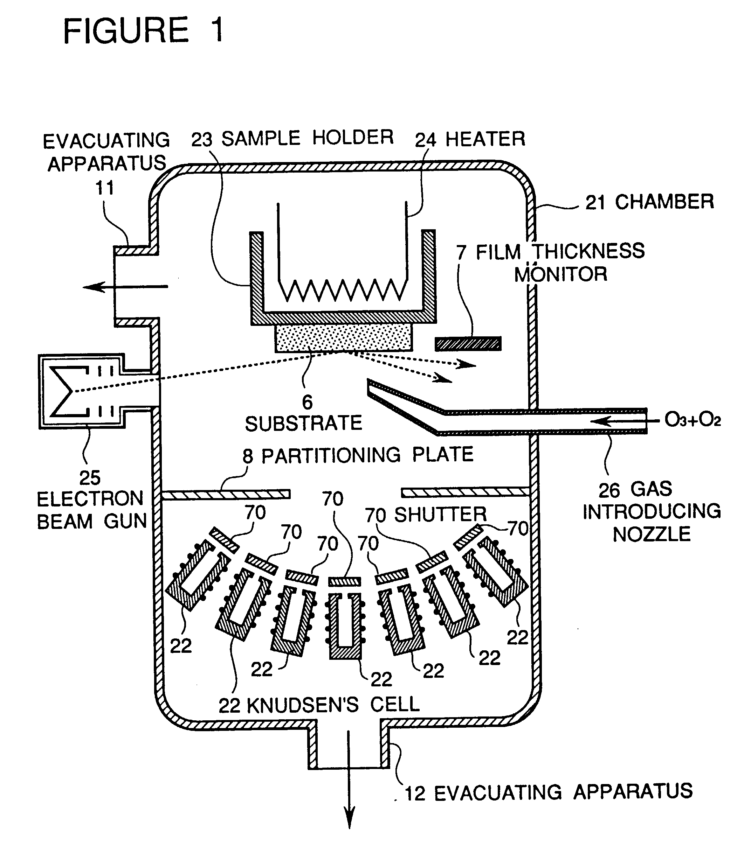

Referring to Figure 1 there is shown a diagrammatic sectional view of a film deposition apparatus which can be used for conducting the process in accordance with the present invention.

This film deposition apparatus includes a vacuum chamber 21 provided with evacuating apparatuses 11 and 12, seven K cells 22 having controllable shutters 70 provided at the bottom of the vacuum chamber 21, and a sample holder 23 provided at the top of the vacuum chamber 21 for holding a substrate 6 on which a film is to be deposited. Shutters 70 and temperatures of the K cells 22 are independently controlled so that the amount of molecular beam flux of each material and deposition rate of compound films are independently controlled. The sample holder 23 is contacted to a heater 24 for heating the substrate and a thermocouple (not shown). A film thickness monitor 7 is provided near the sample holder 23. In addition, the vacuum chamber 21 also has an electron beam gun 25 of Reflecting High Energy Electron Diffraction (RHEED) measurement for observing roughness and crystallinity of a thin film even during the deposition. Though not shown, a liquid nitrogen shroud for cooling outer shells of the K cells 22.

Additionally, a gas introducing nozzle 26 is provided so as to introduce an oxidizing gas such as O₂, O₃, NO₂, N₂O, etc. to the vicinity of the substrate 6 attached to the sample holder 23, so that the oxidizing gas can be supplied to form an oxygen-enriched atmosphere in the vicinity of the substrate 6 in order to oxidize metal molecular beams supplied from the evaporation sources in the course of the film deposition.

Furthermore, the film deposition apparatus additionally includes a partitioning plate 8 for dividing the vacuum chamber 1 into a bottom sub-chamber which consists of a lower portion of the vacuum chamber defined below the partitioning plate 8, which has the K cells 22 and the main evacuating apparatus 12, and a top sub-chamber which consists of an upper portion of the vacuum chamber defined above the partitioning plate 8 and in which sample holder 23 is located. The partitioning plate 8 includes a round shape opening formed at a center thereof. The position of the opening is determined to ensure that molecular beams emitted from K cells toward the substrate 6 are not obstructed by the partitioning plate 8. In addition, the size of the opening is determined to enable restricted oxygen leakage from the top sub-chamber to the bottom sub-chamber so that a pressure difference can be created between these two sub-chambers. Therefore, the partitioning plate 8 having the round shape opening acts as a vacuum conductance.

In addition , the evacuating apparatus 11 is connected to the top sub-chamber for evacuating the top sub-chamber to an ultra-high vacuum. The auxiliary evacuating apparatus 11 is constituted of a cryopump. On the other hand, the evacuating apparatus 12 is constituted of a diffusion or turbo pumps.

### Example 1

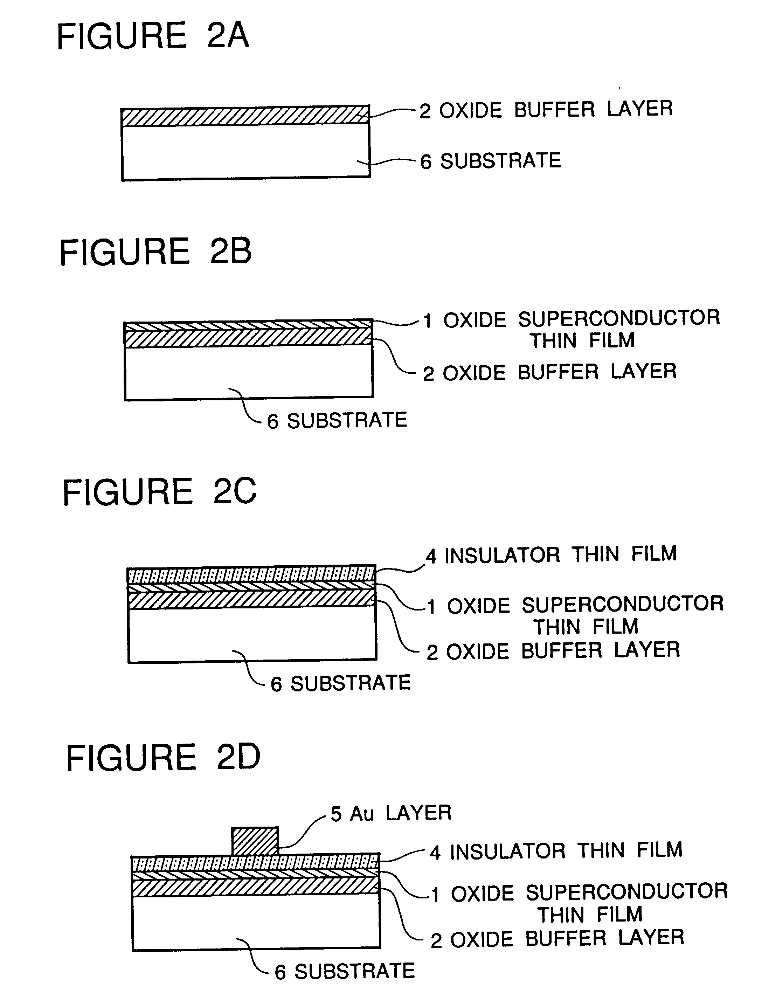

Referring to Figures 2A to 2F, a process for forming the layered structure in accordance with the present invention by using the apparatus shown in Figure 1 will be described.

As shown in Figure 2A, an oxide buffer layer 2 of Pr₁Ba₂Cu₃O_{7-y} (0<y<1) having a thickness of 30 nanometers was deposited on a SrTiO₃ (100) single crystalline substrate 6 by reactive co-evaporation method. At first, SrTiO₃ (100) substrate 6 was attached to the sample holder 23, and metal praseodymium, metal yttrium, metal barium, copper, metal strontium, metal titanium and Au were put into tantalum crucibles held within the seven K cells 20 used as evaporation sources. Thereafter, inlets of the chamber 1 were closed and evacuation process by the evacuating apparatuses 11 and 12 began to reach an ultra-high vacuum which obtained a pressure lower than 1.33·10⁻⁸ Pa (1 × 10⁻¹⁰ Torr), which was required to the background pressure during the film deposition by the MBE process. Succeedingly, an oxidizing gas of O₂ including more than 70 volume percent O₃ was supplied from the gas introducing nozzle 26 so that the oxidation gas partial pressure in the top sub-chamber became 6.66·10⁻⁴ Pa (5 × 10⁻⁶ Torr).

As mentioned above, the vacuum chamber 1 was provided with the vacuum conductance (the partitioning plate 8), a pressure difference of about one digit or more was created between the bottom sub-chamber and the top sub-chamber. Oxidation gas partial pressure of the bottom sub-chamber was maintained low enough to prevent the evaporation sources from oxidization and to maintain the metal molecular beams from each evaporation source during the deposition. In addition, the oxidizing gas injected from the gas introducing nozzle 6 was supplied onto a specimen surface, the partial pressure of the oxidizing gas on the deposition plane of the specimen was maintained enough amount for the oxide film formation.

Then, the substrate 6 was heated by the heater 4 to a temperature of 730 °C. The K cell 22 of metal praseodymium was heated to a temperature of 920 °C, the K cell 22 of metal barium was heated to a temperature of 620 °C and the K cell 22 of metal copper was heated to a temperature of 1000 °C. The temperatures of the K cells are determined by the amount of metal molecular beam fluxes requested by the arrangement of the apparatus and oxide composition.

When molecular beams had reached to their stable operation, the shutters 70 were opened so as to start deposition of the Pr₁Ba₂Cu₃O_{7-y} oxide thin film onto the substrate 6. At the same time, surface crystallinity of this deposited film was observed by the RHEED device.

Then, all the shutters 70 of the K cells 22 were closed and the K cell 22 of metal yttrium was heated to a temperature of 1220 °C. At the same time, the substrate temperature was lowered to 700 °C. Other conditions were kept the same. When molecular beams had reached to their stable operation, again, the shutters 70 of the K cells 22 of yttrium, barium and copper were opened so as to start deposition of a Y₁Ba₂Cu₃O₇₋ₓ (0<x<1) oxide superconductor thin film 1 onto the Pr₁Ba₂Cu₃O_{7-y} oxide buffer layer 2, as shown Figure 2B. At the same time, surface crystallinity of this deposited film was observed by the RHEED device.

Pr₁Ba₂Cu₃O_{7-y} oxide has a crystal structure similar to that of Y₁Ba₂Cu₃O₇₋ₓ oxide superconductor so that the oxide buffer layer 2 of Pr₁Ba₂Cu₃O_{7-y} oxide moderates lattice mismatch between the SrTiO₃ substrate and the Y₁Ba₂Cu₃O₇₋ₓ oxide superconductor thin film 1. In addition, the buffer layer 2 prevents interdiffusion between them. Even if constituent elements of Pr₁Ba₂Cu₃O_{7-y} oxide buffer layer 2 diffuse into the Y₁Ba₂Cu₃O₇₋ₓ oxide superconductor thin film 1, properties of the oxide superconductor thin film 1 are not affected.

When the Y₁Ba₂Cu₃O₇₋ₓ oxide superconductor thin film 1 was grown up to have a thickness of 10 nanometers, all the shutters 70 of the K cells 22 were closed and the K cell 22 of metal strontium was heated to a temperature of 520 °C and the K cell 22 of metal titanium was heated to a temperature of 1500 °C. The substrate temperature was lowered to 400 °C. Other conditions were kept the same. When molecular beams had reached to their stable operatioin, the shutters 70 of the K cells 22 of barium, strontium and titanium were opened so as to start deposition of the Ba_{0.4}Sr_{0.6}TiO₃ insulator thin film 4 having a thickness of 50 nanometers onto the Y₁Ba₂Cu₃O₇₋ₓ oxide superconductor thin film 1, as shown in Figure 2C.

In situ observation with the RHEED device made it clear that the Ba_{0.4}Sr_{0.6}TiO₃ insulator thin film 4 was deposited sequentially, which was formed of a Ba_{0.4}Sr_{0.6}TiO₃ single crystal, and had an uniform thickness.

Then, all the shutters 70 were closed again and the K cell 22 of Au was heated to a temperature of 500 °C. At the same time, the oxidizing gas was stopped so that the chamber 21 was evacuated to a pressure of 4.0 · 10⁻⁸ Pa (3 × 10-¹⁰ Torr). After Au molecular beam had reached to its stable operation, the shutter 70 of the K cell 22 of Au was opened so as to start deposition of an Au layer 5 having a thickness of 200 nanometers onto a the Ba_{0.4}Sr_{0.6}TiO₃ insulator thin film 4 at a substrate temperature of 400 °C, and then the Au layer 5 is patterned to a gate electrode, as shown in Figure 2D.

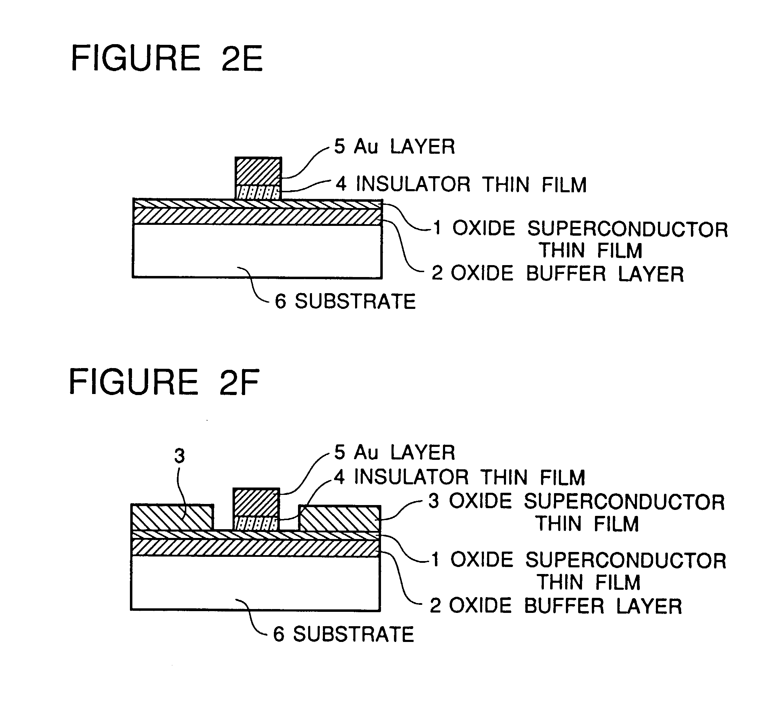

Thereafter, by using the Au layer 5 as a mask, exposed portions of the Ba_{0.4}Sr_{0.6}TiO₃ insulator thin film 4 was completely removed by ion milling using Ar ions so that the Y₁Ba₂Cu₃O₇₋ₓ oxide superconductor thin film 1 was exposed, as shown in Figure 2E. The exposed surface of the Y₁Ba₂CU₃O₇₋ₓ oxide superconductor thin film 1 was observed by XPS without exposing the sample to the air, so that it became clear that little strontium was remained on the exposed surface. This was considered that barium had a tendency to be entrapped in or to combine with Y₁Ba₂Cu₃O₇₋ₓ oxide superconductor so as to prevent strontium from forming strontium contained amorphous. The entrapped barium did not affect on superconducting properties of the Y₁Ba₂Cu₃O₇₋ₓ oxide superconductor.

Then, another Y₁Ba₂Cu₃O₇₋ₓ oxide superconductor thin film 3 having a thickness of 200 nanometers was deposited selectively on the exposed surface of the Y₁Ba₂Cu₃O₇₋ₓ oxide superconductor thin film 1 by using a metal mask under the same condition as mentioned above, as shown in Figure 2F.

The contact resistance between the Y₁Ba₂Cu₃O₇₋ₓ oxide superconductor thin films 1 and 3 was measured by four-terminal method. The measured value of the contact resistance was lower than 10⁻⁶ Ωcm².

In addition, a measured value of dielectric constant ε of the Ba_{0.4}Sr_{0.6}TiO₃ insulator thin film 4 was 200 at the room temperature. Therefore, it is favorable that the above structure is applied to a superconducting field effect device.

### Example 2

Another layered structure utilizing a tri-layer insulator film consisting of a BaTiO₃ thin film, a Ba_{0.2}Sr_{0.8}TiO₃ thin film and a SrTiO₃ thin film was manufactured by using the apparatus shown in Figure 1.

At first, a Pr₁Ba₂Cu₃O_{7-y} oxide buffer layer was deposited on a SrTiO₃ (100) substrate and a Y₁Ba₂CU₃O₇₋ₓ, oxide superconductor thin film was deposited on the Pr₁Ba₂Cu₃O_{7-y} oxide buffer layer. The thickness of the Pr₁Ba₂Cu₃O_{7-y} oxide buffer layer and the Y₁Ba₂Cu₃O₇₋ₓ oxide superconductor thin film were equal to those of Example 1. In addition, the conditions for depositing the thin films were also equal to those of Example 1.

Thereafter, the temperature of the K cell of metal barium was kept 620 °C, the K cell of metal strontium was heated to a temperature of 540 °C and the K cell of metal titanium was heated to a temperature of 1500 °C. The substrate temperature was lowered to 400 °C. Other conditions were kept the same. When molecular beams had reached to their stable operation, the shutters of the K cells of barium and titanium were opened so as to start deposition of a BaTiO₃ thin film having a thickness of 20 nanometers onto the Y₁Ba₂Cu₃O₇₋ₓ oxide superconductor thin film.

In situ observation with the RHEED device made it clear that the BaTiO₃ thin film was deposited sequentially, which was formed of a BaTiO₃ single crystal, and had an uniform thickness.

Then, all the conditions were kept the same and the shutter of the K cell of strontium was opened so as to deposit a Ba_{0.2}Sr_{0.8}TiO₃ thin film having a thickness of 20 namometers on the BaTiO₃ thin film.

In situ observation with the RHEED device made it clear that the Ba_{0.2}Sr_{0.8}TiO₃ thin film was deposited sequentially, which was formed of a Ba_{0.2}Sr_{0.8}TiO₃ single crystal, and had an uniform thickness.

Thereafter, the shutter of the K cell of barium was closed so as to deposit a SrTiO₃ thin film having a thickness of 20 nanometers on the Ba_{0.2}Sr_{0.8}TiO₃ thin film. The conditions were kept the same.

In situ observation with the RHEED device made it clear that the SrTiO₃ thin film was deposited sequentially, which was formed of a SrTiO₃ single crystal, and had an uniform thickness.

Then, all the shutters were closed again and the K cell of Au was heated to a temperature of 500 °C. At the same time, the oxidizing gas was stopped so that the chamber was evacuated to a pressure of 4.0·10⁻⁸ Pa (3 × 10⁻¹⁰ Torr). After Au molecular beam had reached to its stable operation, the shutter of the K cell of Au was opened so as to start deposition of an Au layer having a thickness of 200 nanometers onto the SrTiO₃ insulator thin film of the tri-layer insulator thin film at a substrate temperature of 400 °C, and then patterned to form a gate electrode.

Thereafter, by using the Au layer as a mask, exposed portions of the tri-layer insulator thin film was completely removed by ion milling using Ar ions so that the Y₁Ba₂Cu₃O₇₋ₓ oxide superconductor thin film was exposed. The exposed surface of the Y₁Ba₂CU₃O₇₋ₓ oxide superconductor thin film was observed by XPS without exposing the sample to the air, so that it became clear that little strontium was detected on the exposed surface.

Then, another Y₁Ba₂Cu₃O₇₋ₓ oxide superconductor thin film having a thickness of 200 nanometers was selectively deposited on the exposed surface of the Y₁Ba₂Cu₃O₇₋ₓ oxide superconductor thin film through a metal mask.

The contact resistance between the Y₁Ba₂Cu₃O₇₋ₓ oxide superconductor thin films was measured by four-terminal method. The measured value of the contact resistance was lower than 10⁻⁶ Ωcm².

In addition, a measured value of equivalent dielectric constant ε of the tri-layer insulator thin film of BaTiO₃ thin film, Ba_{0.2}Sr_{0.8}TiO₃ thin film and SrTiO₃ thin film was 250 at the room temperature. Therefore, it is favorable that the above structure is applied to a superconducting field effect device.

### Example 3

Still another layered structure utilizing a Ba_{z}Sr_{1-z}TiO₃ (0≤z≤1) gradient composition insulator film in which z was equal to 1 at the bottom and z was equal to 0 at the top was manufactured by using the apparatus shown in Figure 1.

At first, a Pr₁Ba₂Cu₃O_{7-y} oxide buffer layer was deposited on a SrTiO₃ (100) substrate and a Y₁Ba₂Cu₃O₇₋ₓ oxide superconductor thin film was deposited on the Pr₁Ba₂Cu₃O_{7-y} oxide buffer layer. The thickness of the Pr₁Ba₂Cu₃O_{7-y} oxide buffer layer and the Y₁Ba₂Cu₃O₇₋ₓ oxide superconductor thin film were equal to those of Examples 1 and 2. In addition, the conditions for depositing the thin films were also equal to those of Example 1 and 2.

Thereafter, the temperature of the K cell of metal barium was kept 620 °C, the K cell of metal strontium was heated to a temperature of 520 °C and the K cell of metal titanium was heated to a temperature of 1500 °C. The substrate temperature was lowered to 400 °C. Other conditions were kept the same. When molecular beams had reached to their stable operation, the shutters of the K cells of barium and titanium were opened and closed changing their durations ratio to obtain desired composition ratio so as to start deposition of a Ba_{z}Sr_{1-z}TiO₃ gradient composition insulator film having a thickness of 20 nanometers onto the Y₁Ba₂Cu₃O₇₋ₓ oxide superconductor thin film. The Ba_{z}Sr_{1-z}TiO₃ gradient composition insulator film had a composition of BaTiO₃, namely z=1, at the bottom which was in contact with the Y₁Ba₂Cu₃O₇₋ₓ oxide superconductor thin film and a composition of SrTiO₃, namely z=0, at the top.

In situ observation with the RHEED device made it clear that the Ba_{z}Sr_{1-z}TiO₃ gradient composition thin film was deposited sequentially and had an uniform thickness.

Then, all the shutters were closed again and the K cell of Au was heated to a temperature of 500 °C. At the same time, the oxidizing gas was stopped so that the chamber was evacuated to a pressure of 4,0 · 10⁻⁸ Pa (3 × 10⁻¹⁰ Torr). After Au molecular beam had reached to its stable operation, the shutter of the K cell of Au was opened so as to start deposition of an Au layer having a thickness of 200 nanometers onto the Ba_{z}Sr_{1-z}TiO₃ gradient composition insulator thin film at a substrate temperature of 400 °C, and then patterned to a gate electrode.

Thereafter, by using the Au layer as a mask, exposed portions of the Ba_{z}Sr_{1-z}TiO₃ gradient composition insulator thin film was completely removed by ion milling using An ions so that the Y₁Ba₂Cu₃O₇₋ₓ oxide superconductor thin film was exposed. The exposed surface of the Y₁Ba₂Cu₃O₇₋ₓ oxide superconductor thin film was observed by XPS without exposing the sample to the air, so that it became clear that little strontium was remained on the exposed surface.

Then, another Y₁Ba₂Cu₃O₇₋ₓ oxide superconductor thin film having a thickness of 200 nanometers was selectively deposited on the exposed surface of the Y₁Ba₂Cu₃O₇₋ₓ oxide superconductor thin film by using a metal mask.

The contact resistance between the Y₁Ba₂Cu₃O₇₋ₓ oxide superconductor thin films was measured by four-terminal method. The measured value of the contact resistance was lower than 10⁻⁶ Ωcm².

In addition, a measured value of dielectric constant ε of the Ba_{z}Sr_{1-z}TiO₃ gradient composition insulator thin film was 300 at the room temperature. Therefore, it is favorable that the above structure is applied to a superconducting field effect device.

In the above processes, if the seven K cells can not be set in one chamber, it is possible to use an apparatus comprising equal to or more than two chambers and in situ sample transfer device connecting the chambers.

Furthermore, the oxide superconductor thin film can be formed of a high-T_{c} (high critical temperature) oxide superconductor material, particularly a high-T_{c} copper-oxide type compound oxide superconductor material, for example a Ln-Ba-Cu-O (Ln means a lanthanoide) compound oxide superconductor materials such as Er₁Ba₂Cu₃O₇₋ᵥ (0<v<1) oxide superconductor material, Ce₁Ba₂Cu₃O_{7-w} (0<w<1) oxide superconductor material, etc. other than Y₁Ba₂Cu₃O₇₋ₓ oxide superconductor material.

The substrate can be formed of for example, an insulator substrate such as a MgO (100) substrate, a SrTiO₃ (100) substrate, a CdNdAlO₄ (001) substrate or others.

The invention has thus been shown and described with reference to the specific embodiments. However, it should be noted that the present invention is in no way limited to the details of the illustrated structures but converts and modifications may be made within the scope of the appended claims.

## Claims

1. A layered structure formed on a substrate (6) comprising a Ly₁Ba₂Cu₃O_{7-δ} wherein Ly means a lanthanoide or yttrium and 0<δ<1 oxide superconductor thin film (1) deposited on the substrate and an insulator thin film (4) of a Ba_{z}Sr_{1-z}TiO₃ with 0≤z≤1 composition deposited on the Ly₁Ba₂Cu₃O_{7-δ} oxide superconductor thin film wherein the insulator thin film has a portion of a Ba_{z}Sr_{1-z}TiO₃ with 0<z≤1 composition formed at its bottom adjacent oxide superconductor thin film.

2. A layered structure as claimed in Claim 1, wherein the insulator thin film (4) is formed of Ba_{0.4}Sr_{0.6}TiO₃.

3. A layered structure as claimed in Claim 1, wherein the insulator thin film (4) is formed of a tri-layer consisting of a BaTiO₃ layer, a Ba_{0.2}Sr_{0.8}TiO₃ layer and a SrTiO₃ layer stacked in the named order.

4. A layered structure as claimed in Claim 1, wherein the insulator thin film (4) is formed of a Ba_{z}Sr_{1-z}TiO₃ with 0≤z≤1 gradient composition insulator film in which z is equal to 1 at its bottom and z is equal to 0 at its top.

5. A layered structure as claimed in Claim 1, wherein the layered structure further comprises a buffer layer (2) between the substrate (6) and the superconductor thin film (1).

6. A layered structure as claimed in Claim 5, wherein the the buffer layer (2) is formed of Pr₁Ba₂Cu₃O₇₋ₓ.

7. A layered structure as claimed in Claim 1, wherein the layered structure further comprises a normal conductor layer (5) deposited on the insulator thin film (4).

8. A layered structure as claimed in Claim 1, wherein the oxide superconductor thin film (1) is formed of a Y-Ba-Cu-O compound oxide superconductor material.

9. A layered structure as claimed in Claim 1, wherein the substrate (6) is formed of an insulator.

10. A layered structure as claimed in Claim 9, wherein the substrate (6) is formed of a material selected from the group consisting of a MgO (100) substrate, a SrTiO₃ (100) substrate and a CdNdAlO₄ (001) substrate.

11. A layered structure as claimed in Claim 7, wherein the layered structure is applied to a gate structure of a superconducting field effect device comprising a superconducting channel of an oxide superconductor and a gate electrode arranged on the superconducting channel through a gate insulator layer.

## Patentansprüche

1. Geschichtete Struktur, die auf einem Substrat (6) ausgebildet ist, mit einer oxidischen supraleitenden Dünnschicht (1) aus Ly₁Ba₂Cu₃O_{7-δ}, wobei Ly ein Lanthanoid oder Yttrium ist und 0<δ<1 ist, die auf dem Substrat abgeschieden ist und mit einer isolierenden Dünnschicht (4) aus einer Ba₂Sr_{1-z}Tio₃-Vebindung, wobei 0≤z≤1 ist, die auf der oxidischen supraleitenden Dünnschicht aus Ly₁Ba₂Cu₃O_{7-δ} abgeschieden ist, wobei die isolierende Dünnschicht einen Bereich aus einer Ba_{z}Sr_{1-z}TiO₃-Verbindung mit 0≤Z≤1 an ihrer Unterseite aufweist, der der oxidischen supraleitenden Dünnschicht benachbart ist.

2. Geschichtete Struktur nach Anspruch 1, bei der die isolierende Dünnschicht (4) aus Ba_{0.4}Sr_{0.6}TiO₃ besteht.

3. Geschichtete Struktur nach Anspruch 1, bei der die isolierende Dünnschicht (4) aus einer Dreifachschicht besteht, die durch eine BaTiO₃-Schicht, eine Ba_{0.2}Sr_{0.8}TiO₃-Schicht und einer SrTiO₃-Schicht gebildet ist, die in dieser Reihenfolge übereinander angeordnet sind.

4. Geschichtete Struktur nach Anspruch 1, bei der die isolierende Dünnschicht (4) aus einer Dünnschicht aus Ba_{z}Sr_{1-z}TiO₃ mit 0≤z≤1 und variabler Zusammensetzung besteht, wobei z an der Unterseite gleich 1 und an der Oberseite gleich 0 ist.

5. Geschichtete Struktur nach Anspruch 1, bei der die geschichtete Struktur außerdem eine Pufferschicht (2) zwischen dem Substrat (6) und der supraleitenden Dünnschicht (1) aufweist.

6. Geschichtete Struktur nach Anspruch 5, bei der die Pufferschicht (2) aus Pr₁Ba₂Cu₃O₇₋ₓ besteht.

7. Geschichtete Struktur nach Anspruch 1, bei der die geschichtete Struktur außerdem eine normal leitende Schicht (5) aufweist, die auf der isolierenden Dünnschicht (4) abgeschieden ist.

8. Geschichtete Struktur nach Anspruch 1, bei der die oxidische supraleitende Dünnschicht (1) aus einem supraleitenden Y-Ba-Cu-O-Verbundoxid besteht.

9. Geschichtete Struktur nach Anspruch 1, bei der das Substrat (6) aus einem Isolator besteht.

10. Geschichtete Struktur nach Anspruch 9, bei der das Substrat (6) aus einem Material besteht, das ausgewählt ist aus der Gruppe bestehend aus einem MgO-(100)-Substrat, einem SrTiO₃-(100)-Substrat und einem CdNdAlO₄-(001)-Substrat.

11. Geschichtete Struktur nach Anspruch 7, bei der die geschichtete Struktur Teil einer Gate-Struktur einer supraleitenden Feldeffekt-Anordnung ist, mit einem supraleitenden Kanal aus einem oxidischen Supraleiter und mit einer Gate-Elektrode, die oberhalb einer Gate-Isolierschicht auf dem supraleitenden Kanal angeordnet ist.

## Revendications

1. Structure stratifiée formée sur un substrat (6) comprenant un film mince d'oxyde supraconducteur (1) Ly₁Ba₂Cu₃O_{7-δ}, Ly désignant un lanthanide ou l'yttrium et 0 < δ < 1, déposé sur le substrat, et un film mince isolant (4) d'une composition de formule Ba_{z}Sr_{1-z}TiO₃ avec 0 ≤ z ≤ 1, déposé sur le film mince d'oxyde supraconducteur Ly₁Ba₂Cu₃O_{7-δ}, le film mince isolant comportant une partie d'une composition de formule Ba_{z}sr_{1-z}TiO₃ avec 0 < z ≤ 1, formée au bas de celui-ci, au voisinage du film mince d'oxyde supraconducteur.

2. Structure stratifiée selon la revendication 1, dans laquelle le film mince isolant (4) est formé de Ba_{0.4}Sr_{0.6}TiO₃.

3. Structure stratifiée selon la revendication 1, dans laquelle le film mince isolant (4) est formé d'une triple couche consistant en une couche de BaTiO₃, en une couche de Ba_{0.2}Sr_{0.8}TiO₃ et en une couche de SrTiO₃, empilées dans l'ordre mentionné.

4. Structure stratifiée selon la revendication 1, dans laquelle le film mince isolant (4) est formé d'un film isolant d'une composition à gradient de formule Ba_{z}Sr_{1-z}TiO₃ avec 0 ≤ z ≤ 1, z étant égal à 1 au bas de celui-ci, et z étant égai à 0 en haut de celui-ci.

5. Structure stratifiée selon la revendication 1, dans laquelle la structure stratifiée comprend en outre une couche tampon (2) entre le substrat (6) et le film mince supraconducteur (1).

6. Structure stratifiée selon la revendication 5, dans laquelle la couche tampon (2) est formée de Pr₁Ba₂Cu₃O₇₋ₓ.

7. Structure stratifiée selon la revendication 1, dans laquelle la structure stratifiée comprend en outre une couche conductrice ordinaire (5) déposée sur le film mince isolant (4).

8. Structure stratifiée selon la revendication 1, dans laquelle le film mince d'oxyde supraconducteur (1) est formé d'une matière supraconductrice de type oxyde mixte Y-Ba-Cu-O.

9. Structure stratifiée selon la revendication 1, dans laquelle le substrat (6) est formé d'un isolant.

10. Structure stratifiée selon la revendication 9, dans laquelle le substrat (6) est formé d'un matériau choisi parmi un substrat de MgO (100), un substrat de SrTiO₃ (100) et un substrat de CdNdAlO₄ (001).

11. Structure stratifiée selon la revendication 7, dans laquelle la structure stratifiée est appliquée sur une structure de grille d'un dispositif supraconducteur à effet de champ, comprenant un canal supraconducteur d'un supraconducteur de type oxyde et une électrode formant grille disposée sur le canal supraconducteur à travers une couche isolante de grille.
